# FASCICULE DE BREVET EUROPEEN

(11) **EP 3 631 485 B1**
(45) Date de publication et mention de la délivrance du brevet: **13.08.2025**
(21) Numéro de dépôt: 18727825.4
(22) Date de dépôt: 01.06.2018
(51) Int. Cl.: G01R 33/00, G01R 33/06, G01R 33/09

(54) **SYSTEME ET PROCEDE DE SUPPRESSION DU BRUIT BASSE FREQUENCE DE CAPTEURS MAGNETO-RESISTIFS A MAGNETORESISTENCE TUNNEL**
SYSTEM UND VERFAHREN ZUR UNTERDRÜCKUNG VON NIEDERFREQUENZRAUSCHEN AUS MAGNETORESISTIVEN SENSOREN MIT TUNNELMAGNETOWIDERSTAND
SYSTEM AND METHOD FOR THE SUPPRESSION OF LOW-FREQUENCY NOISE FROM MAGNETORESISTIVE SENSORS WITH TUNNEL MAGNETORESISTANCE

(30) Priorité: 02.06.2017 FR 1754902
(43) Date de publication de la demande: 08.04.2020
(73) Titulaire: Commissariat à l'Energie Atomique et aux Energies Alternatives, 75015 Paris (FR)
(72) Inventeur: PANNETIER-LECOEUR, Myriam, 91440 Bures Sur Yvette (FR); SOLIGNAC, Aurélie, 91300 Massy (FR); TRAUCHESSEC, Vincent, 75019 Paris (FR); FERMON, Claude, 91400 Orsay (FR)
(74) Mandataire: Cabinet Camus Lebkiri
(86) Numéro de dépôt international: PCT/EP2018/064504
(87) Numéro de publication internationale: WO 2018/220194

(56) Documents cités:
- EP-A1- 2 165 206
- EP-A2- 2 165 210
- US-A1- 2008 224 695

## Description

### DOMAINE DE L'INVENTION

La présente invention concerne un système et un procédé de suppression du bruit basse fréquence d'un capteur de type magnéto-résistif. Les capteurs magnéto-résistifs couvrent en particulier les capteurs de type magnétorésistance tunnel (« Tunnel Magnetoresistance » en anglais ou TMR) ou des capteurs à magnétoresistance colossale (« Colossal Magnetoresistance » en anglais ou CMR).

### ART ANTERIEUR

Le bruit basse fréquence des capteurs magnéto-résistifs comme les TMRs est considéré aujourd'hui comme l'obstacle majeur pour leur utilisation dans certaines applications demandant une très grande détectivité dans les basses fréquences. Un exemple de ces applications est la mesure de champs magnétiques en milieu biologique, tels que les champs magnétiques associés aux signaux physiologiques et en particulier aux signaux neuronaux. Ces signaux varient lentement, avec des fréquences inférieures à 1 KHz et leur détection est affectée par le bruit basse fréquence du capteur utilisé lors de la mesure.

Pour les capteurs de type Magnetorésistance anisotrope (« Anisotropic Magnetoresistance » en anglais ou AMR) une méthode de changement de direction de courant permet de supprimer une partie de leur bruit en 1/f (voir par exemple I. Mateos et al. « Low-frequency noise characterization of a magnetic field monitoring system using an anisotropic magnetoresistance », publié dans Sensors and Actuators A, Volume 235, 2015). Cette technique ne peut pas être appliquée pour les GMRs et les TMRs car leur résistance et leur changement de résistance ne dépendent pas de la direction du courant.

Des techniques de modulation du champ vu par le capteur peuvent être appliquées. Ces techniques déplacent le point de fonctionnement du capteur hors de son bruit basse fréquence. Des exemples de telles techniques sont décrites dans les articles « Towards picoTesla Magnetic Field Detection Using a GMR-MEMS Hybrid Device » de A. Guedes et al., publié dans IEEE TRANSACTIONS ON MAGNETICS, Vol. 48, N. 11 Pages 4115-4118, 2012, et « Minimizing 1/f noise in magnetic sensor using a microelectromechanical system flux concentrator", de A. S. Edelstein et al., publié dans Journal of Applied Physics, Vol. 91, page 7795, 2002.

Ces publications proposent d'utiliser des concentrateurs de flux modulés en fréquence mais cette technique donne des résultats modestes et exige l'utilisation de MEMS (« Micro Electro-mechanical systems » an anglais) pour effectuer une modulation mécanique.

Dans le cas particulier de capteurs couplés à des boucles de courant supraconductrices, une modulation du supercourant peut relativement efficacement supprimer le bruit basse fréquence en déplaçant aussi le point de fonctionnement du capteur à plus haute fréquence. De telles solutions sont décrites est décrit dans les documents de brevets EP2165206 et EP2165210.

La publication US2008224695 A1 divulgue un autre capteur magnéto-résistif, comprenant des moyens de modulation pour réduire le bruit basse fréquence.

Toutefois ces techniques présentent plusieurs inconvénients tels que des difficultés de mise en œuvre, une faible efficacité ou encore l'utilisation de matériaux supraconducteurs qui requièrent des conditions d'utilisation spécifiques et peuvent avoir des coûts élevés.

### RESUME DE L'INVENTION

L'invention vise à résoudre les problèmes mentionnés ci-dessus en proposant un système de suppression de bruit basse fréquence de capteurs magnéto-résistifs à magnétorésistance tunnel, à savoir des capteurs comprenant au moins une jonction tunnel magnétique TMR, ce système étant fiable, de faible encombrement et réalisable industriellement.

A cette fin, un premier objet de l'invention est un système de suppression du bruit basse fréquence de capteurs magnéto-résistifs à magnétorésistance tunnel, ledit système de suppression comprenant :
- Un dispositif de mesure d'un champ magnétique, ledit dispositif comprenant au moins un capteur à magnétorésistance tunnel, ledit capteur à magnétorésistance tunnel ayant une première sensibilité à un premier point de fonctionnement et une deuxième sensibilité à un deuxième point de fonctionnement, la deuxième sensibilité au deuxième point de fonctionnement étant différente de la première sensibilité au premier point de fonctionnement ;
- Des moyens de modulation adaptés pour faire basculer l'au moins un capteur à magnétorésistance tunnel du premier point de fonctionnement au deuxième point de fonctionnement et du deuxième point de fonctionnement au premier point de fonctionnement, lesdits moyens ayant une première configuration correspondante au premier point de fonctionnement et une deuxième configuration correspondante au deuxième point de fonctionnement ;
- Des moyens de traitement du signal issu du dispositif de mesure d'un champ magnétique, lesdits moyens de traitement étant adaptés pour réaliser une combinaison linéaire d'une première réponse du dispositif de mesure en présence du champ magnétique au premier point de fonctionnement correspondant à la première configuration des moyens de modulation et une deuxième réponse du dispositif de mesure en présence du champ magnétique au deuxième point de fonctionnement correspondant à la deuxième configuration des moyens de modulation.

On entend par capteur à magnétorésistance tunnel C un élément ayant une résistance électrique dépendante du champ magnétique extérieur et comprenant au moins une jonction magnétique tunnel TMR ou CMR. Dans une jonction TMR le passage de courant se fait par effet tunnel à travers une couche mince isolante placée entre deux électrodes ferromagnétiques. L'orientation de l'aimantation d'une des deux électrodes dépend du champ magnétique extérieur. En mesurant la variation de résistance aux bornes de l'élément C, il est possible de mesurer le champ magnétique extérieur. On entend par champ magnétique extérieur ou par champ magnétique le champ magnétique que l'on veut mesurer.

Chaque capteur à magnétorésistance tunnel C utilisé dans le cadre de la présente invention possède des points de fonctionnements différents ayant une sensibilité différente.

Plus grande est la différence de sensibilité entre les deux points de fonctionnement retenus pour la mise en œuvre de l'invention, plus reproductible et fiable sera la suppression du bruit basse fréquence.

On entend par moyens de modulation M des moyens permettant de modifier périodiquement la sensibilité des capteurs magnéto-résistifs utilisés. Les moyens M peuvent comprendre un générateur de tension variable dans le temps ou un générateur de fonctions.

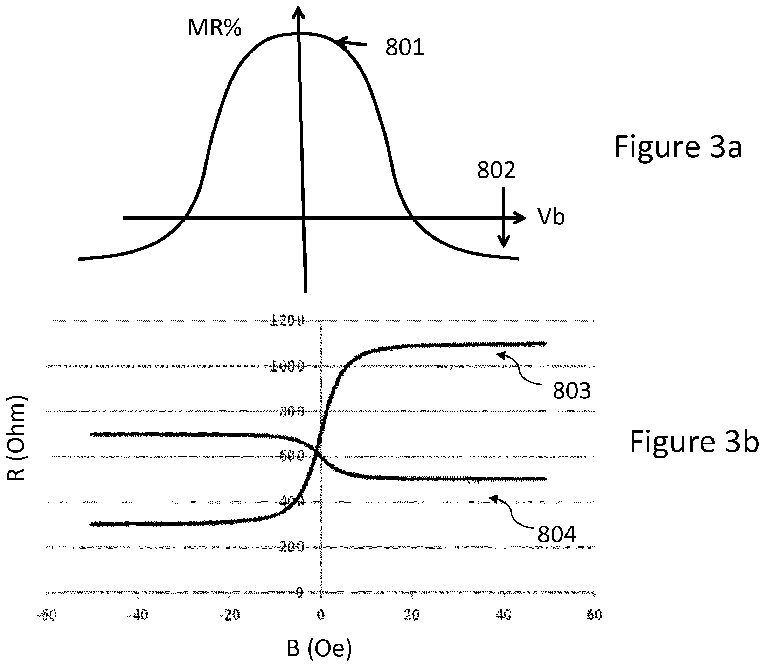

En effet, le principe de l'invention est basé sur une propriété des capteurs à magnétorésistance tunnel qui est donnée par la hauteur en énergie finie de la barrière tunnel. Ainsi en augmentant la tension aux bornes de la TMR, la sensibilité au champ extérieur diminue, comme il est montré à la figure 3b.

La modulation effectuée par les moyens M est par exemple une variation périodique de la sensibilité des capteurs magnéto-résistifs C. La fréquence de cette modulation est supérieure à la fréquence du bruit basse fréquence que l'on veut éliminer.

On entend par moyens de traitement du signal T des moyens utilisés pour sélectionner la réponse M1 du dispositif D quand les capteurs à magnétorésistance tunnel sont au premier point de fonctionnement et la réponse M2 du dispositif D quand les capteurs sont au deuxième point de fonctionnement. Les moyens de traitement du signal T sont aussi adaptés pour réaliser une combinaison linéaire des réponses M1 et M2. Les moyens de traitement T peuvent comprendre des circuits analogiques, des circuits numériques ou un mélange de circuits analogiques et numériques.

Le bruit basse fréquence associé à un capteur magnéto-résistif C est, comme dans tous les conducteurs, un bruit de fluctuations de résistance. Par ailleurs, le champ extérieur crée lui aussi un changement de résistance. En cas d'utilisation d'un capteur magnéto-résistif pour mesurer un champ magnétique lentement variable, les deux variations de résistance ne peuvent donc pas être séparées par une seule mesure.

L'invention proposée se base sur un principe différent de ceux proposés jusqu'à maintenant. Elle consiste à faire osciller le capteur magnéto-résistif à magnétorésistance tunnel C entre deux points de fonctionnement différents. Les deux points sont choisis de telle sorte que la réponse à un champ magnétique extérieur soit différente. La réponse du capteur au champ magnétique extérieur est aussi appelée sensibilité du capteur. L'oscillation du capteur entre deux points de fonctionnement différents est également appelée modulation de la sensibilité du capteur.

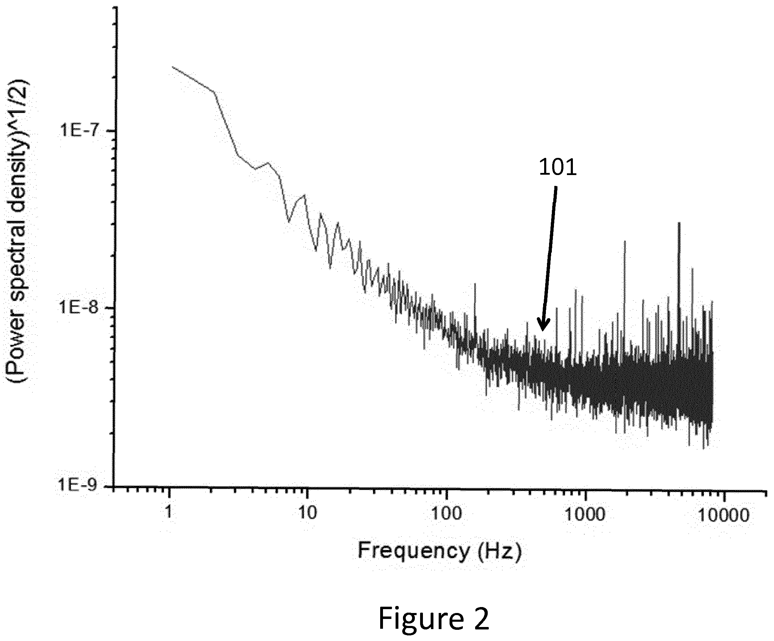

En d'autres termes, l'invention consiste à faire osciller le capteur entre ces deux points de mesure à une fréquence plus rapide que le domaine de bruit en 1/f comme indiqué sur la figure 2 et donc à mesurer à haute fréquence la réponse du capteur dans chaque état. On obtient ainsi deux courbes indépendantes, M1 et M2, les deux courbes étant fonctions du temps. Une combinaison linéaire de ces deux courbes permet d'obtenir une courbe uniquement dépendante du champ extérieur et une courbe donnant les fluctuations de résistance internes.

La reconstitution de ces deux courbes, M1 et M2, peut être faite soit numériquement, soit analogiquement.

L'invention sera d'autant plus efficace que les deux points correspondent à des sensibilités très différentes. Par exemple, dans le cas d'une conception de jonction à magnétorésistance tunnel ajustée avec des barrières antisymétriques, la sensibilité au champ magnétique extérieur peut même se renverser à forte tension.

Le dispositif selon l'invention permet donc de séparer les variations de résistance d'un capteur magnéto-résistifs dues au bruit basse fréquence et les variations de résistances dues à l'effet du champ magnétique extérieur B. Autrement dit, le dispositif selon l'invention permet de supprimer le bruit basse fréquence de capteurs magnéto-résistifs.

Le dispositif selon l'invention peut également présenter une ou plusieurs des caractéristiques ci-dessous, considérées individuellement ou selon toutes les combinaisons techniquement possibles, tant qu'elles entrent dans la portée des revendications annexées :
- le dispositif D de mesure d'un champ magnétique B comprend deux capteurs à magnétorésistance tunnel 301, 302 disposés selon un montage en demi-pont et un préamplificateur PA bas bruit, les deux capteurs magnétorésistance tunnel C ayant une réponse au champ magnétique inversée, le montage en demi-pont comprenant un premier bras B1 et un deuxième bras B2, les deux bras étant connectés en parallèle, chacun de bras comprenant une résistance R et un des capteurs à magnétorésistance tunnel 301, 302, le montage en demi-pont comprenant en outre une première V+ et une deuxième V- sortie, les deux sorties étant connectées au préamplificateur PA bas bruit, chaque sortie V+, V- étant le point de jonction entre une des résistances R et un des capteurs à magnétorésistance tunnel 301, 302 ;
- le dispositif de mesure D comprend un premier 401, 401a et un deuxième 402, 402a couple de capteurs à magnétorésistance tunnel et un préamplificateur PA bas bruit, les capteurs du premier couple 401, 401a ayant une réponse inversée par rapport aux capteurs du deuxième couple 402, 402a, les capteurs à magnétorésistance tunnel 401, 401a, 402, 402a étant disposés selon un montage en pont, le montage en pont comprenant un premier bras B1 et un deuxième bras B2, les deux bras étant connectés en parallèle, chacun de bras comprenant un capteur à magnétorésistance tunnel du premier couple 401, 401a et un capteur à magnétorésistance tunnel du deuxième couple 402, 402a, le montage en pont comprenant en outre une première V+ et une deuxième V- sortie, les deux sorties étant connectées au préamplificateur PA bas bruit, chaque sortie V+, V- étant le point de jonction entre un capteur à magnétorésistance tunnel du premier couple 401, 401a et un capteur à magnétorésistance tunnel du deuxième couple 402, 402a ;
- le montage en demi-pont ou en pont est connecté à une tension Vb, la tension Vb étant pilotée par les moyens de modulation M ;
- le montage en demi-pont ou en pont est connecté à une première tension Vb/2 et à une deuxième tension -Vb/2, la tension Vb étant pilotée par les moyens de modulation M ;
- chaque capteur C à magnétorésistance tunnel est formé par un ensemble de jonctions à magnétorésistance tunnel connectées en série ;
- le dispositif D de mesure comprend des moyens de chauffage local de sorte à retourner la couche de référence 703, 704 d'au moins un des capteurs à magnétorésistance tunnel ;
- les moyens de modulation M comprennent une horloge générale à haute fréquence pour la génération d'un signal de commutation entre le premier point de fonctionnement 801 et le deuxième point de fonctionnement 802 ;
- le signal de commutation comprend un signal de tension Vb variable dans le temps, ledit signal étant connecté au montage en demi-pont ou au montage en pont, le signal Vb étant destiné à la commutation des capteurs à magnétorésistance tunnel entre le premier point de fonctionnement 801 et le deuxième point de fonctionnement 802 ;
- les moyens de traitement T du signal issu du dispositif D de mesure d'un champ magnétique B comprennent un dispositif d'acquisition numérique rapide du signal issu du préamplificateur PA ;
- les moyens de traitement T du signal issu du dispositif D de mesure d'un champ magnétique B comprennent :
   - Un premier circuit Sample and Hold destiné à enregistrer le signal M1 mesuré par le dispositif D de mesure au premier point de fonctionnement 201 ;
   - Un deuxième circuit Sample and Hold destiné à enregistrer le signal M2 mesuré par le dispositif D de mesure au deuxième point de fonctionnement 202 ;
   - Un système d'acquisition numérique ou analogique 1301 pour la combinaison linéaire des signaux issus du premier et deuxième circuit Sample and Hold.
- l'horloge générale génère en outre un premier signal de contrôle du premier circuit Sample and Hold et un deuxième signal de contrôle du deuxième circuit Sample and Hold.

Un autre objet de l'invention est un procédé de suppression de bruit basse fréquence associé à la mesure d'un champ magnétique par un dispositif de mesure comprenant au moins un capteur magnéto-résistif, ledit procédé comprenant les étapes suivantes :
- Identifier un premier et un deuxième point de fonctionnement de l'au moins un capteur magnéto-résistif, le capteur magnéto-résistif ayant une première sensibilité au premier point de fonctionnement et une deuxième sensibilité au deuxième point de fonctionnement, la sensibilité au deuxième point de fonctionnement étant faible ou nulle ;
- Moduler la sensibilité du capteur magnéto-résistif en faisant basculer le capteur magnéto-résistif du premier point de fonctionnement ayant la première sensibilité au deuxième point de fonctionnement ayant la deuxième sensibilité et du deuxième point de fonctionnement au premier point de fonctionnement ;
- Lors de la modulation, mesurer une première réponse du dispositif de mesure D en présence du champ magnétique au premier point de fonctionnement S1 et une deuxième réponse M2 du dispositif de mesure en présence du champ magnétique au deuxième point de fonctionnement ;
- Calculer une combinaison linéaire de la première réponse M1 et de la deuxième réponse M2 du système de mesure D.

La première étape du procédé selon l'invention permet d'identifier les deux points de fonctionnement des capteurs à magnétorésistance tunnel compris dans le dispositif D, les deux points de fonctionnement ayant deux sensibilités différentes.

Avantageusement, le deuxième point de fonctionnement est choisi de sorte à avoir une sensibilité au champ magnétique différente du premier point de fonctionnement. Cela permet de différencier les fluctuations de résistance dues au bruit basse fréquence du capteur C des variations de résistance dues au champ magnétique extérieur.

La sensibilité du capteur est ensuite modulée, par exemple à l'aide des moyens de modulation M, de sorte à faire basculer les capteurs à magnétorésistance tunnel du dispositif D entre les deux points de fonctionnement.

Il est donc possible de mesurer la réponse du dispositif D au premier et au deuxième point de fonctionnement, de sorte à identifier les fluctuations de résistance dues majoritairement au bruit basse fréquence en condition de sensibilité faible ou nulle des éléments à magnétorésistance tunnel.

Le procédé selon l'invention peut également présenter une ou plusieurs des caractéristiques ci-dessous, considérées individuellement ou selon toutes les combinaisons techniquement possibles , tant qu'elles entrent dans la portée des revendications annexées :
- la fréquence de modulation MOD de la sensibilité du capteur C à magnétorésistance tunnel est supérieure à la fréquence 101 à laquelle le bruit basse fréquence devient inférieur au bruit thermique associé au capteur C à magnétorésistance tunnel ;
- la sensibilité du capteur C à magnétorésistance tunnel est au moins deux fois supérieure à la fréquence 101 à laquelle le bruit basse fréquence devient inférieur au bruit thermique associé au capteur C à magnétorésistance tunnel ;
- le dispositif de mesure D comprend deux capteurs à magnétorésistance tunnel 301, 302 disposés selon un montage en demi-pont et un préamplificateur PA, les deux capteurs à magnétorésistance tunnel ayant une réponse au champ magnétique inversée, le montage en demi-pont comprenant un premier bras B1 et un deuxième bras (B2), les deux bras étant connectés en parallèle, chacun de bras comprenant une résistance (R) et un des capteurs à magnétorésistance tunnel 301, 302, le montage en demi-pont comprenant en outre une première V+ et une deuxième V-sortie, les deux sorties étant connectées au préamplificateur bas bruit, chaque sortie V+, V- étant le point de jonction entre une des résistances R et un des capteurs à magnétorésistance tunnel 301, 302 ;
- que le dispositif de mesure D comprend un premier 401, 401a et un deuxième 402, 402a couple de capteurs à magnétorésistance tunnel et un préamplificateur bas bruit, les capteurs du premier couple 401, 401a ayant une réponse inversée par rapport aux capteurs du deuxième couple 402, 402a, les capteurs à magnétorésistance tunnel 401,401a, 402, 402a étant disposés selon un montage en pont, le montage en pont comprenant un premier bras B1 et un deuxième bras B2, les deux bras étant connectés en parallèle, chacun de bras comprenant un capteur à magnétorésistance tunnel du premier couple 401,401a et un capteur à magnétorésistance tunnel du deuxième couple 402, 402a, le montage en pont comprenant en outre une première (V+) et une deuxième V- sortie, les deux sorties étant connectées au préamplificateur bas bruit, chaque sortie V+, V- étant le point de jonction entre un capteur à magnétorésistance tunnel du premier couple 401, 401a et un capteur à magnétorésistance tunnel du deuxième couple 402, 402a ;
- l'étape MOD de modulation de la sensibilité de l'au moins un capteur à magnétorésistance tunnel est réalisée par application d'une tension V aux bornes de capteur C à magnétorésistance tunnel, de sorte à changer la sensibilité du capteur C à magnétorésistance tunnel quand la tension V est appliquée ;
- l'étape de mesure MES de la première réponse M1 du dispositif D de mesure et de la deuxième réponse M2 du dispositif D de mesure est réalisée à l'aide d'un système d'acquisition numérique ou analogique 1101 ;
- l'étape de combinaison linéaire LIN est réalisée à l'aide d'un système d'acquisition numérique ou analogique 1301.

### LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 montre un schéma du système S de réduction du bruit basse fréquence selon un objet de l'invention ;
- la figure 2 montre la densité spectrale de bruit en 1/f ou bruit basse fréquence ;
- la figure 3a montre la variation de la magnétorésistance d'une jonction à magnétorésistance tunnel TMR en fonction de la tension appliquée aux bornes de la jonction ;
- la figure 3b montre les variations de résistance d'une jonction à magnétorésistance tunnel TMR en fonction du champ magnétique extérieur ;
- la figure 4 montre un premier exemple de dispositif de mesure D associé au système S de réduction du bruit basse fréquence tel que donné à la figure 1 ; dans ce cas un montage en demi-pont avec deux éléments magnéto-résistifs est représenté ;
- la figure 5a montre un deuxième exemple de dispositif de mesure D associé au système S de réduction du bruit basse fréquence tel que donné à la figure 1 ; dans ce cas un montage en pont complet avec quatre éléments magnéto-résistifs est représenté ;
- la figure 5b montre un troisième exemple de dispositif de mesure D associé au système S de réduction du bruit basse fréquence tel que donné à la figure 1 ; dans ce cas le pont est alimenté symétriquement ;
- la figure 6 montre un empilement typique d'une jonction magnétorésistance tunnel TMR ;
- la figure 7 illustre schématiquement un mode de réalisation du système S de suppression du bruit basse fréquence avec un traitement numérique du signal issus du dispositif D de mesure ;
- la figure 8 montre le schéma électronique d'un mode de réalisation du système S de suppression du bruit basse fréquence permettant d'obtenir les deux courbes M1 et M2 de façon analogique et de réaliser une combinaison linéaire digitale ;
- la figure 9 montre le schéma électronique d'un mode de réalisation du système S de suppression du bruit basse fréquence permettant d'obtenir les deux courbes M1 et M2 de façon analogique et de réaliser une combinaison linéaire analogique ;
- la figure 10 montre un exemple de signaux issus des moyens de modulation M et permettant de moduler la sensibilité des capteurs à magnétorésistance tunnel TMR ; la figure 10 montre également les signaux utilisés pour piloter les circuits de traitement analogique des signaux M1 et M2 ;
- la figure 11 montre les étapes du procédé de mise en œuvre du système de réduction du bruit selon l'invention.

### DESCRIPTION DETAILLEE DE L'INVENTION

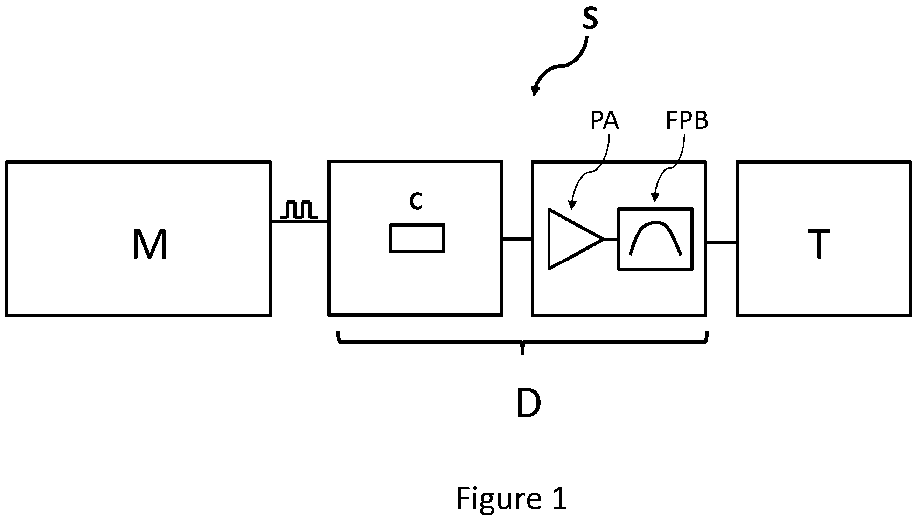

La figure 1 montre un exemple du système S de réduction du bruit basse fréquence selon l'invention. Le système S comprend :
- des moyens de modulation M utilisés pour moduler la sensibilité d'au moins un capteur C à magnétorésistance tunnel ; les moyens de modulation comprennent par exemple un générateur de tension ou un générateur de fonction pour générer une tension variable dans le temps ;
- un dispositif D de mesure d'un champ magnétique extérieur B ; le dispositif D comprend au moins un capteur à magnétorésistance tunnel C, un amplificateur bas-bruit PA pour l'amplification du signal issu du capteur magnéto-résistif C et un filtre passe bande FPB pour éliminer les composantes basses et hautes fréquences du signal mesuré par D ; il est important de noter que chaque capteur magnéto-résistif faisant partie du dispositif D possède des points de fonctionnement différents avec des sensibilités au champ magnétique extérieur B différentes ; le dispositif D fournit une première mesure M1 et une deuxième mesure M2 issue du dispositif D ;
- un dispositif de traitement du signal T pour enregistrer les deux mesures M1 et M2 et/ou réaliser la combinaison linéaire de la première mesure M1 et de la deuxième mesure M2.

La figure 2 montre un exemple de densité spectrale de bruit en 1/f d'un capteur magnéto-résistif. La densité spectrale de bruit est représentée en fonction de la fréquence. Sur cette figure on voit que le bruit basse fréquence devient inférieur au bruit thermique à partir de la fréquence 101. Dans ce cas, il faut que la fréquence d'oscillation entre les deux points de fonctionnement soit supérieure à la fréquence 101 et si cela est possible, au moins deux fois supérieure à la fréquence correspondant au point 101.

La fréquence d'oscillation entre les deux points de fonctionnement ayant sensibilités différentes est également appelée fréquence de modulation de la sensibilité des capteurs magnéto-résistifs.

Avantageusement, il vaut mieux choisir 'une fréquence de modulation suffisamment élevée, c'est-à-dire au-delà de la fréquence où les fluctuations de résistance deviennent égales au bruit thermique.

La figure 3a montre la variation de la magnétorésistance d'une jonction à magnétorésistance tunnel TMR en fonction de la tension appliquée Vb. Les points 801 et 802 montrent les deux points ayant une sensibilité différente et retenus pour la mise en œuvre de l'invention.

La figure 3b montre la variation de magnétorésistance d'une jonction à magnétorésistance tunnel TMR en fonction du champ extérieur B. La courbe 803 représente la variation de magnétorésistance en fonction du champ extérieur B au point de fonctionnement 801. La courbe 804 représente la variation de magnétorésistance en fonction du champ extérieur B au point de fonctionnement 802.

Sur la figure 3b on voit que grâce à l'application de la tension Vb la sensibilité au champ magnétique extérieur décroit et peut être inversée.

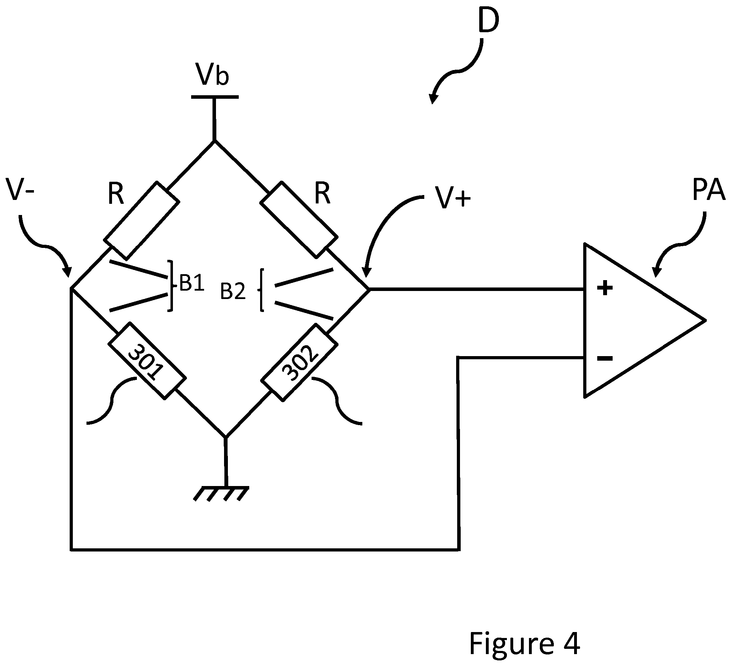

La figure 4 montre un premier mode de réalisation du dispositif de mesure D du système S selon l'invention. Selon ce mode de réalisation le dispositif de mesure D comprend deux capteurs à magnétorésistance tunnel 301 et 302 et deux résistances R identiques. Ces quatre éléments sont connectés selon un montage en demi-pont illustré à la figure 4.

En particulier le montage en demi-pont comprend une tension Vb d'alimentation connectée à un premier bras B1 et à un deuxième bras B2. Les deux bras sont connectés en parallèle. L'extrémité des bras B1 et B2 opposée à l'extrémité connectée à la tension Vb est connectée à la masse. Chacun des deux bras B1 et B2 comprend une résistance R et un élément à magnétorésistance tunnel 301, 302. Dans l'exemple illustré à la figure 4, la tension d'alimentation Vb est connectée au point de jonction entre les deux résistances R. Alternativement, la tension Vb peut être connectée au point de jonction entre les deux capteurs à magnétorésistance tunnel 301 et 302.

Chaque bras B1, B2 du montage de la figure 4 comprend une sortie V-, V+. Les deux sorties V-, V+ sont connectées à un préamplificateur bas bruit PA.

Les deux capteurs magnéto-résistif 301 et 302 ont une réponse au champ extérieur inversée. Autrement dit, sous l'action du champ magnétique extérieur et uniforme dans le volume occupé par le pont de la figure 4, une augmentation de magnétorésistance du premier capteur magnéto-résistif 301 correspond à une diminution de magnétorésistance du deuxième capteur magnéto-résistif 302.

Avantageusement, cela permet de mesurer une différence de potentiel entre les deux sorties V+ et V- qui est proportionnel au champ magnétique extérieur B à mesurer.

Pour mettre en œuvre l'invention, il est nécessaire de moduler la sensibilité des capteurs magnéto-résistifs à magnétorésistance tunnel 301 et 302 entre le premier point de fonctionnement 801 ayant une première sensibilité S1 et le deuxième point de fonctionnement 802 ayant une deuxième sensibilité S2. Cette modulation peut être obtenue en appliquant une tension Vb variable dans le temps et déplaçant le point de fonctionnement des capteurs à magnétorésistance tunnel du premier point de fonctionnement 801 au deuxième point de fonctionnement 802 et vice-versa. La tension Vb peut être pilotée par les moyens de modulation M.

Avantageusement, le montage en demi-pont permet d'avoir une sortie indépendante du point de fonctionnement des capteurs magnéto-résistifs. Autrement dit, la tension différentielle en sortie du pont de la figure 4 quand les éléments magnéto-résistifs sont au premier point de fonctionnement 201 est proche de la tension différentielle quand les éléments magnéto-résistif sont au point de saturation 202.

Cette configuration est très avantageuse car dans les deux cas il est possible d'amplifier la tension de sortie du pont sans saturer le préamplificateur bas bruit PA.

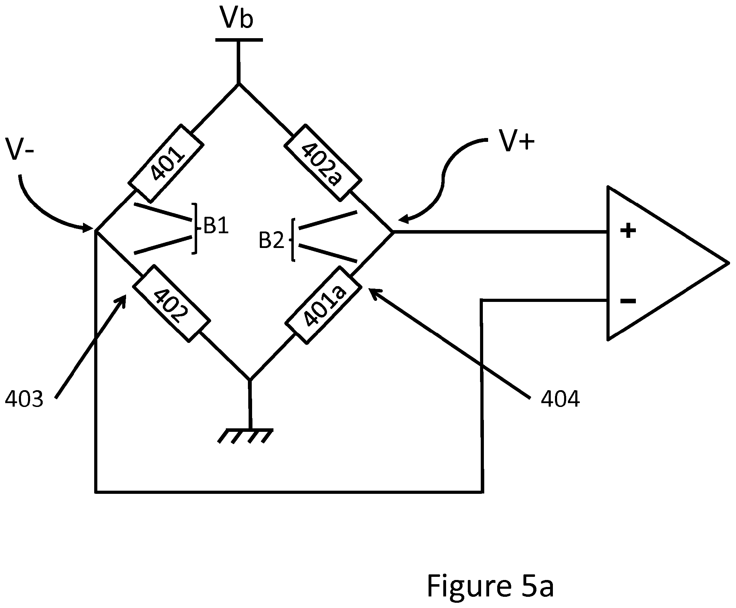

La figure 5a montre un deuxième mode de réalisation du dispositif de mesure D pour le système S de réduction de bruit basse fréquence. Dans ce cas on a un montage en pont complet avec quatre éléments à magnétorésistance tunnel. Les éléments 401 et 401a ont une réponse au champ magnétique extérieur B inversée par rapport aux éléments 402 et 402a.

Le fonctionnement du circuit de la figure 5a est similaire au fonctionnement de la figure 4. Le point de fonctionnement des capteurs à magnétorésistance tunnel peut être changé en appliquant une tension Vb variable dans le temp. La tension Vb peut être pilotée par les moyens de modulation M.

Avantageusement, le montage en pont permet d'avoir une sortie indépendante du point de fonctionnement des capteurs magnéto-résistifs à magnétorésistance tunnel et d'autre part permet de gagner un facteur 2 sur l'amplitude de sortie.

A la fois dans le cas du montage en demi-pont illustré à la figure 4 et dans le cas du montage en pont illustré à la figure 5a, les éléments magnéto-résistifs doivent avoir une réponse au champ magnétique extérieur inversée. Cette réponse inversée peut être obtenue suivant des procédés déjà connus : le premier consiste à monter 4 capteurs identiques mais physiquement renversés. Cette méthode est simple à utiliser mais nécessite d'avoir deux dies de silicium indépendants et donc présente un coût commercial plus important. Le second procédé consiste à retourner par un moyen de chauffage local la couche de référence des deux éléments à magnétorésistance tunnel 402, 402a par un chauffage local sous champ. Le troisième procédé consiste à déposer deux empilements légèrement différents qui ont des réponses inversées mais très proches. Dans un mode préférentiel, nous appliquons le deuxième procédé qui permet d'avoir un procédé industrialisable à faible coût.

Le premier point de fonctionnement 801 du capteur à magnétorésistance tunnel correspond à un courant tel que la tension aux bornes de l'élément à magnétorésistance tunnel lui donne une sensibilité très grande. Une valeur typique de tension est 100mV par jonction. Dans ce mode préférentiel une série de jonctions à magnétorésistance tunnel, typiquement 20 à 30 en série, sont utilisées afin d'avoir une tension de sortie de l'ordre de 2V ou 3V pour le premier point de fonctionnement qui est le mode où les éléments à magnétorésistances sont les plus sensibles. Dans ce cas chaque capteur à magnétorésistance tunnel C est formé par une série de jonctions magnétiques tunnel TMR.

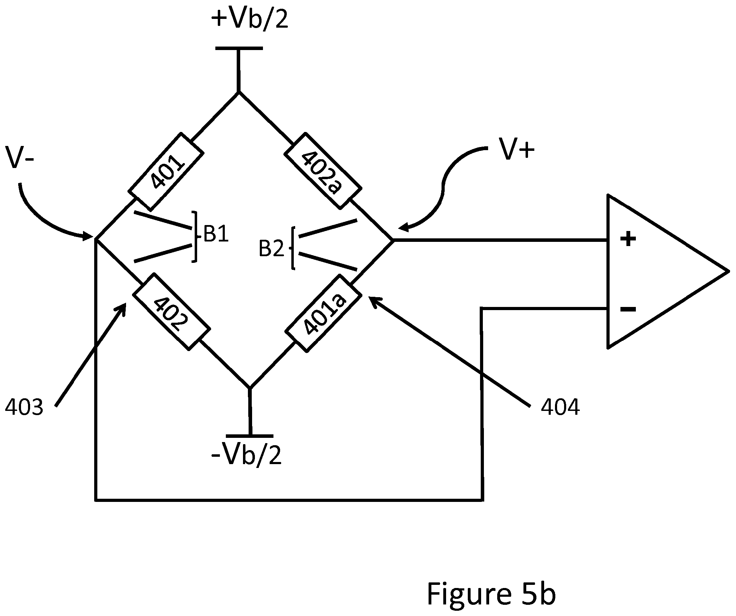

Le deuxième point de fonctionnement correspond à un courant dans le capteur à magnétorésistance tunnel produisant une tension de l'ordre du volt par élément donc de 20 à 30V pour une série d'éléments. Afin de simplifier l'électronique en aval, il est possible d'alimenter le pont en tension symétrique comme montré en figure 5b. A ce moment, le premier point correspond à +-1V sur le pont et le deuxième point à +-10V sur le pont. Dans ce cas, le préamplificateur PA d'entrée ne sature pas.

Il peut y avoir des petits transitoires rapides lors de l'application du courant et sa suppression.

Avantageusement, la tension Vb ou les tensions +/- Vb/2 peuvent être pilotée par les moyens de modulation M. Par exemple, une première valeur de Vb correspond à la première configuration des moyens de modulation M et une deuxième valeur de Vb correspond à la deuxième configuration des moyens de modulation M.

Avantageusement, le point de fonctionnement des éléments à magnétorésistance tunnel peut être contrôlé grâce aux moyens de modulations M.

Le dispositif D du système S selon l'invention est donc capable de fournir une première mesure M1 correspondant au premier point de fonctionnement des capteurs à magnétorésistance tunnel. Cette première mesure M1 correspond aux points de type 801 sur la figure 3a. Le dispositif D est aussi capable de fournir une deuxième mesure M2 correspondant au deuxième point de fonctionnement des capteurs à magnétorésistance tunnel. La deuxième mesure M2 correspond aux points de type 802 sur la figure 3b.

Avantageusement, les mesures M2 et M1 sont des courbes indépendantes contenant à la foi les fluctuations de résistances dues au champ magnétique extérieur B et les fluctuations intrinsèques de résistances correspondantes au bruit basse fréquence.

En réalisant une combinaison linéaire des mesures M1 et M2 il est donc possible d'éliminer le bruit basse fréquence. Dans le mode 801, le signal est la somme des fluctuations de résistance à tension Vb1 et du champ extérieur multiplié par la sensibilité à ce point. Dans le mode 802, le signal est la somme des fluctuations de résistance à tension Vb2 et de la sensibilité à ce point. Afin d'avoir une valeur du champ indépendante des fluctuations des résistances, il faut réaliser la soustraction du signal obtenu au point 801 et du signal obtenu au point 802 multiplié par VB1/VB2.

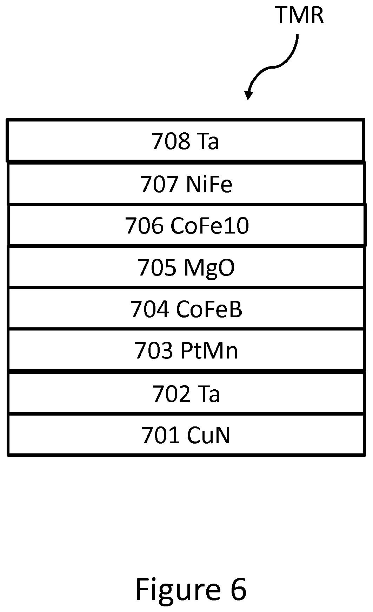

La figure 6 montre un empilement typique d'une jonction à magnétorésistance tunnel TMR. La couche 701, souvent un alliage de Cu de type CuN sert d'électrode inférieure. La couche 702 sert de couche de croissance. Les couches 703 un antiferromagnetique de type PtMn ou IrMn couplé à une couche de type CoFeB 704 servent de référence. La barriere est formée de Al2O3 ou préférentiellement MgO 705. Les couches 706 et 707 forment une couche libre classique. C'est-à-dire une couche qui suit le champ extérieur. La couche 708 sert de protection et de départ pour le contact supérieur de la jonction tunnel.

Il existe de nombreuses variantes d'empilement connus de la littérature. L'empilement asymétrique donné ici permet d'avoir une sensibilité inversée à forte tension.

Un capteur magnéto-résistif C à magnétorésistance tunnel peut comprendre une seule jonction TMR ou une multiplicité de jonctions TMR connectées en série.

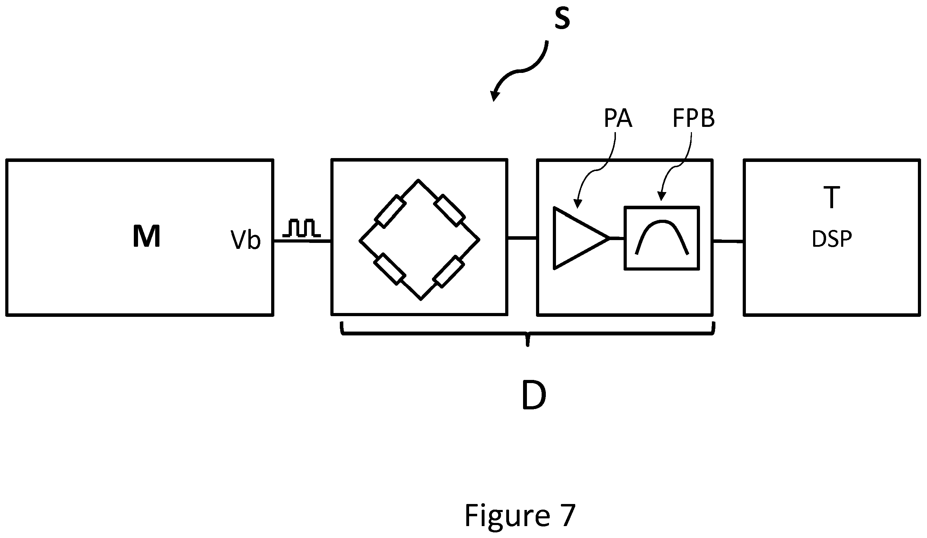

La figure 7 montre un exemple de mise en œuvre du système S selon l'invention en cas d'acquisition digitale directe et reconstruction digitale du signal non bruité.

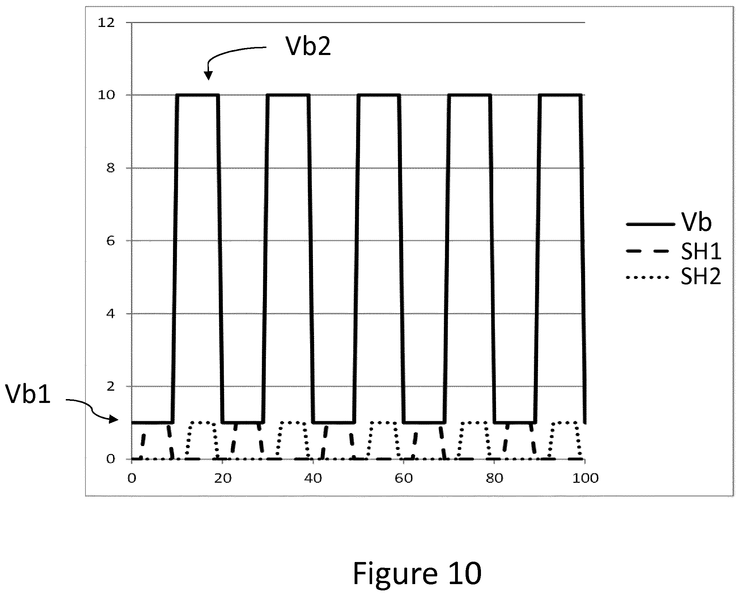

Les moyens de modulation M génèrent un signal Vb périodique de fréquence f et d'impulsion de largeur ajustable. De façon indicative, f se situera souvent entre 10kHz et 10MHz suivant la taille des TMR choisies. Le signal Vb alimente le demi-pont de figure 4 ou le pont de figure 5a. Alternativement les moyens de modulations M peuvent fournir les tensions +/-Vb/2 pour l'alimentation du pont de la figure 5b. Une valeur typique de largeur des impulsions constituant le sigal Vb est 50% du cycle total. Un exemple de signal Vb est le signal 1601 de la figure 10. En sortie du pont, un preamplificateur PA bas bruit ainsi qu'un filtre FPB coupant les fréquences au-dessus de f et bien en dessous conditionne le signal qui est acquis, converti numériquement et traité par les moyens de traitement numérique DSP.

Les moyens de modulation M selon le mode de réalisation de la figure 7 comprennent par exemple un générateur de tension un générateur d'impulsions ou un générateur de fonctions pour générer le signal Vb variable dans le temps. Le signal Vb peut être un signal carré comme le signal Vb illustré à la figure 10. Il est important de noter que le signal Vb illustré à la figure 10 varie entre une première valeur Vb1 correspondante à la première configuration des moyens de modulation M et une deuxième valeur Vb2 correspondante à la deuxième configuration des moyens de modulation M. Selon le mode de réalisation représenté à la figure 10 Vb1 est inférieur à Vb2.

La première configuration des moyens de modulation M correspond au premier point de fonctionnement 801 des capteurs à magnétorésistance tunnel C et la deuxième configuration des moyens de modulation M correspond au deuxième point de fonctionnement 802 des capteurs à magnétorésistance tunnel C.

Le préamplificateur très bas bruit PA doit avoir une bande passante d'au moins 5 fois la vitesse de commutation.

Les moyens de traitement numérique du signal DSP réalisent une acquisition très rapide typiquement à une fréquence d'échantillonnage autour de 10 MHz. Le signal est acquis directement en sortie du filtre FPB. Dans ce cas, tout le traitement se fait de façon digitale. Les points après chaque transition de champ appliqué sont moyennés. On reconstruit ainsi les deux courbes M1 et M2. Ces deux courbes sont ensuite soustraites pour obtenir le signal non bruité.

Avantageusement, ce mode de réalisation est facile à mettre en œuvre, grâce à l'utilisation des moyens de traitement numérique du signal DSP.

D'autres modes de réalisation reposent sur l'utilisation de moyens de traitement T analogique du signal.

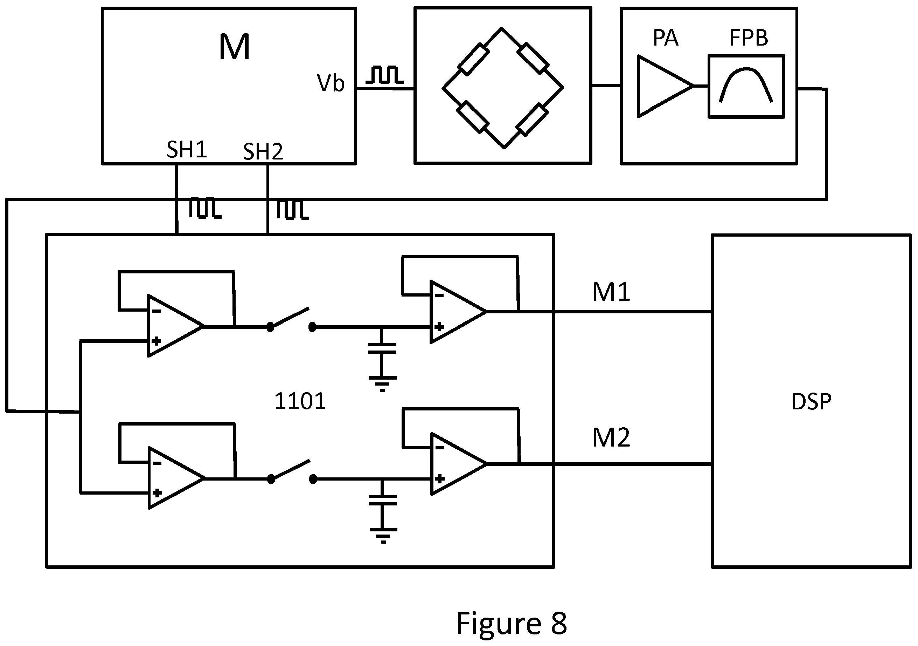

La figure 8 montre un exemple de schéma électrique permettant d'obtenir les deux courbes indépendantes M1 et M2 de façon analogique et une combinaison linéaire réalisée digitalement grâce aux moyens de traitement numérique DSP. En plus des modules déjà présents sur la figure 7, un double Sample & Hold 1101 est inséré. Il est commandé par les moyens de modulation M qui génèrent à ce moment 3 signaux. Un premier signal Vb est destiné à alimenter un montage de type demi-pont ou pont selon les figures 4, 5a ou 5b. Deux signaux SH1 et SH2 d'amplitude et de largeur d'impulsions sont envoyés aux Sample & Hold 1101. Ainsi les deux S&H 1101 séparent les signaux mesurés lorsque les capteurs à magnétorésistance tunnel C sont au premier point de fonctionnement 801, mesure M1, et lorsque les capteurs à magnétorésistance tunnel sont au deuxième point de fonctionnement 802, mesure M2. Les deux signaux M1 et M2 sont stockés, convertis et soustraits pour obtenir le signal non bruité. Ces opérations de stockage et soustraction des mesures M1 et M2 sont réalisées par les moyens de traitement numérique du signal DSP.

Plus particulièrement, le fonctionnement des deux circuits S&H 1101 est expliqué en relation à la figure 10 qui montre les signaux générés par le générateur de fonctions compris dans les moyens de modulation M. L'échelle des abscisses est en µs à titre purement illustratif et non limitatif.

Le générateur de fonctions a le rôle d'une horloge générale à haute fréquence f typiquement 1MHz et génère trois signaux Vb, SH1, SH2. Le signal Vb pilote la mise en place de la commutation des capteurs à magnétorésistance tunnel C et permet de passer du premier point de fonctionnement 801 au deuxième point de fonctionnement 802. Le signal SH1 pilote un premier S&H 1101, le signal SH2 pilote le deuxième S&H 1101.

La figure 10 montre qu'un premier circuit S&H est en mode acquisition pendant que le signal Vb a une première valeur Vb1, ce qui correspond au premier point de fonctionnement 801 des capteurs à magnétorésistance tunnel C du dispositif D. Ce premier circuit S&H permet de remonter à la mesure M1. Au contraire, le deuxième circuit S&H est en mode acquisition pendant que le signal Vb a une deuxième valeur Vb2, ce qui correspond au deuxième point de fonctionnement 802 des capteurs à magnétorésistance tunnel C du dispositif D. Ce deuxième circuit S&H permet de remonter à la mesure M2.

La première configuration des moyens de modulations M correspond au niveau faible du signal Vb : les capteurs à magnétorésistance tunnel C sont au premier point de fonctionnement 301. La deuxième configuration des moyens de modulation M correspond au niveau élevé du signal Vb : les capteurs à magnétorésistance tunnel C sont au deuxième point de fonctionnement.

Avantageusement, cette façon de piloter les circuits S&H permet de séparer les mesures M1 et M2 en utilisant une électronique simple à réaliser et de faible coût.

Le décalage temporel entre le signal Vb et les deux signaux SH1 et SH2 est tel que les circuits S&H sont mis en mode acquisition après un petit temps en fin de commutation et en mode mémoire avant la commutation suivante comme montré sur la figure 12.

Avantageusement, ce décalage temporel permet d'écarter les transitoires qui suivent une commutation et de rendre plus précise l'élimination du bruit basse fréquence.

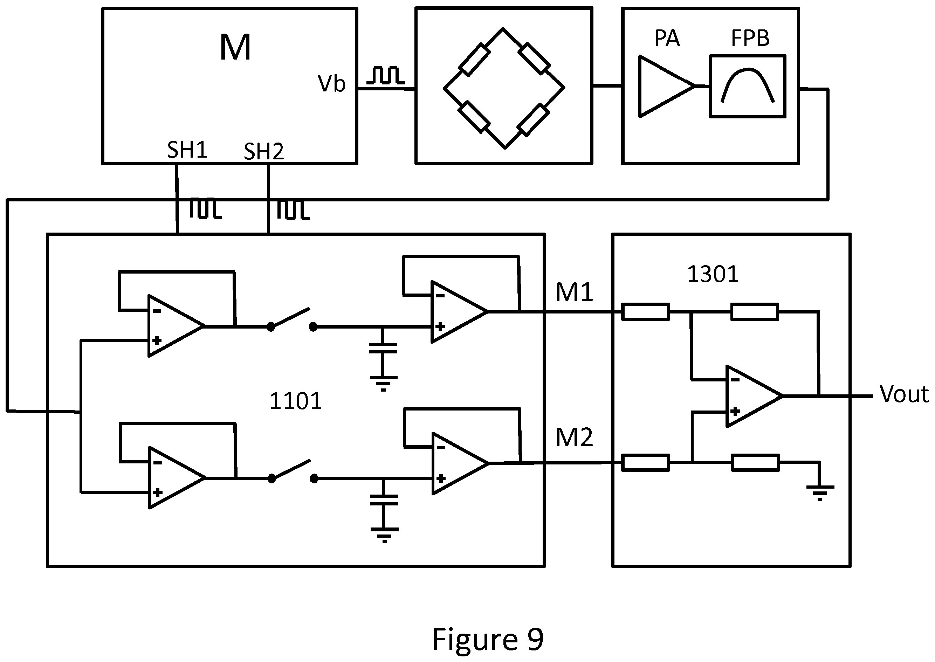

La figure 9 montre un troisième exemple de réalisation du système S selon l'invention, avec une étape de traitement du signal entièrement analogique. A la différence du dispositif de la figure 8, cette fois les moyens de traitement numérique du signal DSP sont remplacés par un circuit soustracteur 1301 capable de réaliser la soustraction des deux mesures M2 et M1 de façon analogique.

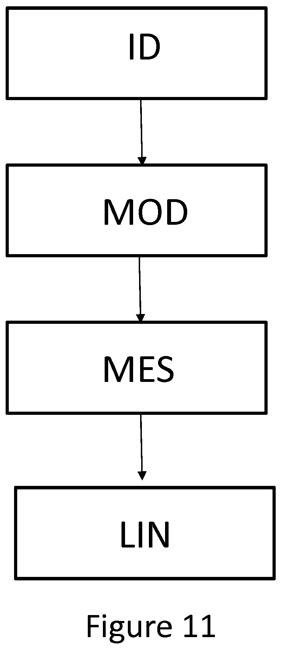

Avantageusement le système de la figure 11 est un système totalement analogique et potentiellement intégrable au niveau du capteur rendant transparent ces étapes de modulation et soustraction pour l'utilisateur.

La figure 12montre les étapes du procédé de mise en œuvre du système S selon l'invention.

Lors d'une première étape ID, les deux points de fonctionnement 801 et 802 des capteurs à magnétorésistance tunnel C faisant partie du dispositif D de mesure du champ extérieur B sont choisis. Les points 801 et 802 sont choisis de sorte à avoir deux sensibilités au champ magnétique extérieur B très différentes. La sensibilité S2 au deuxième point de fonctionnement 802 peut même être inversée par rapport à la sensibilité S1 au premier point de fonctionnement 801.

Lors de la deuxième étape MOD les moyens de modulation M sont utilisés pour faire basculer les capteurs à magnétorésistance tunnel C du premier point de fonctionnement 801 ayant la première sensibilité S1 au deuxième point de fonctionnement 802 ayant la deuxième sensibilité S2 et du deuxième point de fonctionnement 802 au premier point de fonctionnement 801.

Lors de l'étape MES, la réponse des capteurs magnéto-résistifs du dispositif D dans la zone de sensibilité et dans la zone de saturation est enregistrée, la modulation de la sensibilité des capteurs magnéto-résistifs étant toujours en cours. La réponse des capteurs magnéto-résistifs dans la zone de saturation, ou mesure M2, contient essentiellement les fluctuations de résistance dues au bruit basse fréquence. La réponse des capteurs magnéto-résistifs dans la zone de sensibilité, ou mesure M1, contient les variations de résistances due aux variations du champ magnétique extérieur, en plus des fluctuations dues au bruit base fréquence. On obtient ainsi deux courbes, M1 et M2 indépendantes, les deux courbes M1 et M2 étant fonction du temps.

Il est donc possible, lors de l'étape LIN, de réaliser une combinaison linéaire des mesures M1 et M2 pour obtenir le signal non bruité et éventuellement une courbe donnant uniquement les fluctuations de résistances internes associées au bruit basse fréquence.

Selon un mode de réalisation, la combinaison linéaire de l'étape LIN consiste à soustraire les deux mesures M1 et M2.

Selon un autre mode de réalisation, lors de l'étape LIN les mesures M1 et M2 sont combinées linéairement selon une formule de type M1 - α M2. α est en général donné par le rapport des tensions appliquées dans la mesure M1 et la mesure M2.

Selon un mode de réalisation du procédé selon l'invention, la fréquence de modulation de la sensibilité des capteurs à magnétorésistance tunnel est supérieure à la fréquence 101 à laquelle le bruit basse fréquence devient inférieur au bruit thermique associé aux capteurs magnéto-résistifs.

Selon un mode de réalisation du procédé, la fréquence de modulation de la sensibilité du capteur est au moins deux fois supérieure à la fréquence 101 à laquelle le bruit basse fréquence devient inférieur au bruit thermique associé aux capteurs magnéto-résistifs.

L'étape MES peut être réalisée à l'aide du dispositif de mesure D. Le dispositif D peut être réalisé selon l'une des configurations illustrées en relation au système S selon l'invention. Ces configurations sont illustrées aux figures4, 5a et 5b.

Les étapes MES et LIN peuvent être réalisée à l'aide des moyens de traitement de signal T. Les moyens de traitement T peuvent être numériques, analogiques ou en partie numériques et en parties analogiques selon l'une des configurations expliquées en relation au système S selon l'invention.

## Revendications

1. Système (S) de suppression du bruit basse fréquence de capteurs magnéto-résistifs à magnétorésistance tunnel (C), ledit système (S) de suppression comprenant un dispositif (D) de mesure d'un champ magnétique (B) et des moyens de modulation (M), ledit système (S) de suppression comprend :
- Ledit dispositif (D) comprenant au moins un capteur (C) à magnétorésistance tunnel, ledit capteur (C) à magnétorésistance tunnel ayant une première sensibilité (S1) à un premier point de fonctionnement (801) et une deuxième sensibilité (S2) à un deuxième point de fonctionnement (802), la deuxième sensibilité (S2) au deuxième point de fonctionnement (802) étant différente de la première sensibilité (S1) au premier point de fonctionnement (801) ;
ledit système étant **caractérisé en ce qu'**il comprend en outre:
- Les moyens de modulation (M) étant adaptés pour faire basculer le capteur (C) à magnétorésistance tunnel du premier point de fonctionnement (801) au deuxième point de fonctionnement (802) et du deuxième point de fonctionnement (802) au premier point de fonctionnement (801), lesdits moyens de modulation (M) ayant une première configuration correspondante au premier point de fonctionnement (801) et une deuxième configuration correspondante au deuxième point de fonctionnement (802) ;
- Des moyens (T) de traitement du signal issu du dispositif (D) de mesure d'un champ magnétique (B), lesdits moyens (T) de traitement étant adaptés pour réaliser une combinaison linéaire d'une première réponse (M1) du dispositif de mesure (D) en présence du champ magnétique (B) au premier point de fonctionnement (801) correspondant à la première configuration des moyens de modulation (M) et une deuxième réponse (M2) du dispositif de mesure (D) en présence du champ magnétique (B) au deuxième point de fonctionnement (802) correspondant à la deuxième configuration des moyens de modulation (M).

2. Système (S) de suppression du bruit basse fréquence de capteurs magnéto-résistifs à magnétorésistance tunnel selon la revendication précédente **caractérisé en ce que** le dispositif (D) de mesure d'un champ magnétique (B) comprend deux capteurs à magnétorésistance tunnel (301, 302) disposés selon un montage en demi-pont et un préamplificateur (PA) bas bruit, les deux capteurs à magnétorésistance tunnel (C) ayant une réponse au champ magnétique inversée, le montage en demi-pont comprenant un premier bras (B1) et un deuxième bras (B2), les deux bras étant connectés en parallèle, chacun de bras comprenant une résistance (R) et un des capteurs à magnétorésistance tunnel (301,302), le montage en demi-pont comprenant en outre une première (V+) et une deuxième (V-) sortie, les deux sorties étant connectées au préamplificateur (PA) bas bruit, chaque sortie (V+, V-) étant le point de jonction entre une des résistances (R) et un des capteurs à magnétorésistance tunnel (301, 302).

3. Système (S) de suppression du bruit basse fréquence de capteurs magnéto-résistifs à magnétorésistance tunnel selon la revendication 1 **caractérisé en ce que** le dispositif de mesure (D) comprend un premier (401, 401a) et un deuxième (402, 402a) couple de capteurs à magnétorésistance tunnel et un préamplificateur (PA) bas bruit, les capteurs du premier couple (401, 401a) ayant une réponse inversée par rapport aux capteurs du deuxième couple (402, 402a), les capteurs à magnétorésistance tunnel (401, 401a, 402, 402a) étant disposés selon un montage en pont, le montage en pont comprenant un premier bras (B1) et un deuxième bras (B2), les deux bras étant connectés en parallèle, chacun de bras comprenant un capteur à magnétorésistance tunnel du premier couple (401, 401a) et un capteur à magnétorésistance tunnel du deuxième couple (402, 402a), le montage en pont comprenant en outre une première (V+) et une deuxième (V-) sortie, les deux sorties étant connectées au préamplificateur (PA) bas bruit, chaque sortie (V+, V-) étant le point de jonction entre un capteur à magnétorésistance tunnel du premier couple (401, 401a) et un capteur à magnétorésistance tunnel du deuxième couple (402, 402a).

4. Système (S) de suppression du bruit basse fréquence de capteurs magnéto-résistifs à magnétorésistance tunnel selon la revendication 2 ou la revendication 3 **caractérisé en ce que** le montage en demi-pont ou en pont est connecté à une tension Vb, la tension Vb étant pilotée par les moyens de modulation M.

5. Système (S) de suppression du bruit basse fréquence de capteurs magnéto-résistifs à magnétorésistance tunnel selon la revendication 2 ou la revendication 3 **caractérisé en ce que** le montage en demi-pont ou en pont est connecté à une première tension Vb/2 et à une deuxième tension -Vb/2, les tensions Vb/2 et - Vb/2 étant pilotées par les moyens de modulation M.

6. Système (S) de suppression du bruit basse fréquence de capteurs à magnétorésistance tunnel selon l'une des revendications précédentes **caractérisé en ce que** chaque capteur (C) à magnétorésistance tunnel est formé par un ensemble de jonctions à magnétorésistance tunnel connectées en série.

7. Système (S) de suppression du bruit basse fréquence de capteurs magnéto-résistifs à magnétorésistance tunnel selon l'une des revendications précédentes **caractérisé en ce que** le dispositif (D) de mesure comprend des moyens de chauffage local de sorte à retourner la couche de référence (703,704) d'au moins un des capteurs à magnétorésistance tunnel.

8. Système (S) de suppression du bruit basse fréquence de capteurs à magnétorésistance tunnel selon l'une des revendications précédentes **caractérisé en ce que** les moyens de modulation (M) comprennent une horloge générale à haute fréquence pour la génération d'un signal (1601) de commutation entre le premier point de fonctionnement (801) et le deuxième point de fonctionnement (802).

9. Système (S) de suppression du bruit basse fréquence selon la revendication précédente et la revendication 3 ou la revendication 4 **caractérisé en ce que** le signal de commutation (1601) comprend la tension Vb variable dans le temps, ledit signal étant connecté au montage en demi-pont ou au montage en pont, la tension Vb étant destinée à la commutation des capteurs à magnétorésistance tunnel entre le premier point de fonctionnement (801) et le deuxième point de fonctionnement (802).

10. Procédé (1) de suppression de bruit basse fréquence associé à la mesure d'un champ magnétique (B) par un dispositif de mesure (D) comprenant au moins un capteur (C) à magnétorésistance tunnel, ledit procédé comprenant les étapes suivantes :
- Identifier (ID) un premier (801) et un deuxième (802) point de fonctionnement du capteur (C) à magnétorésistance tunnel, le capteur à magnétorésistance tunnel ayant une première sensibilité (S1) au premier point de fonctionnement (801) et une deuxième sensibilité (S2) au deuxième point de fonctionnement (802), la sensibilité (S2) au deuxième point de fonctionnement étant différente de la première sensibilité (S1) ;
ledit procédé étant en outre **caractérisé par** les étapes suivantes:
- Moduler (MOD) la sensibilité du capteur (C) à magnétorésistance tunnel en faisant basculer le capteur (C) à magnétorésistance tunnel du premier point de fonctionnement (801) ayant la première sensibilité (S1) au deuxième point de fonctionnement (802) ayant la deuxième sensibilité (S2) et du deuxième point de fonctionnement (802) au premier point de fonctionnement (801) ;
- Lors de la modulation (MOD), mesurer (MES) une première réponse (M1) du dispositif de mesure (D) en présence du champ magnétique (B) au premier point de fonctionnement (801) et une deuxième réponse (M2) du dispositif de mesure (D) en présence du champ magnétique (B) au deuxième point de fonctionnement (802) ;
- Calculer une combinaison linéaire (LIN) de la première réponse (M1) et de la deuxième réponse (M2) du dispositif de mesure (D).

## Patentansprüche

1. System (S) zur Unterdrückung des Niederfrequenzrauschens von magnetoresistiven Sensoren mit Tunnelmagnetowiderstand (C), wobei das Unterdrückungssystem (S) eine Vorrichtung (D) zur Messung eines Magnetfelds (B) und Modulationsmittel (M) sowie Folgendes umfasst:
- Die Vorrichtung (D) umfasst mindestens einen Tunnelmagnetowiderstandssensor (C), wobei der Tunnelmagnetowiderstandssensor (C) eine erste Empfindlichkeit (51) an einem ersten Betriebspunkt (801) und eine zweite Empfindlichkeit (S2) an einem zweiten Betriebspunkt (802) aufweist, wobei sich die zweite Empfindlichkeit (S2) am zweiten Betriebspunkt (802) von der ersten Empfindlichkeit (51) am ersten Betriebspunkt (801) unterscheidet;
wobei das System **dadurch gekennzeichnet ist, dass** es außerdem Folgendes umfasst:
- die Modulationsmittel (M), die dazu geeignet sind, den Tunnelmagnetowiderstandssensor (C) vom ersten Betriebspunkt (801) zum zweiten Betriebspunkt (802) und vom zweiten Betriebspunkt (802) zum ersten Betriebspunkt (801) umzuschalten, wobei die Modulationsmittel (M) eine erste Konfiguration entsprechend dem ersten Betriebspunkt (801) und eine zweite Konfiguration entsprechend dem zweiten Betriebspunkt (802) aufweisen;
- Mittel (T) zur Verarbeitung des Signals, das von der Vorrichtung (D) zur Messung eines Magnetfelds (B) stammt, wobei die Verarbeitungsmittel (T) geeignet sind, eine Linearkombination aus einer ersten Antwort (M1) der Messvorrichtung (D) in Gegenwart des Magnetfelds (B) am ersten Betriebspunkt (801), der der ersten Konfiguration der Modulationsmittel (M) entspricht, und einer zweiten Antwort (M2) der Messvorrichtung (D) in Gegenwart des Magnetfelds (B) am zweiten Betriebspunkt (802), der der zweiten Konfiguration der Modulationsmittel (M) entspricht, zu realisieren.

2. System (S) zur Unterdrückung des Niederfrequenzrauschens von magnetoresistiven Tunnelmagnetowiderstandssensoren nach dem vorhergehenden Anspruch, **dadurch gekennzeichnet, dass** die Vorrichtung (D) zum Messen eines Magnetfelds (B) zwei Tunnelmagnetowiderstandssensoren (301, 302), die in einer Halbbrückenanordnung angeordnet sind, und einen rauscharmen Vorverstärker (PA) umfasst, wobei die beiden Tunnelmagnetowiderstandssensoren (C) eine umgekehrte Magnetfeldantwort aufweisen, die Halbbrückenschaltung einen ersten Arm (B1) und einen zweiten Arm (B2) umfasst, wobei die beiden Arme parallel geschaltet sind, wobei jeder der Arme einen Widerstand (R) und einen der Tunnelmagnetowiderstandssensoren (301, 302) umfasst, die Halbbrückenanordnung ferner einen ersten (V+) und einen zweiten (V-) Ausgang umfasst, wobei beide Ausgänge mit dem rauscharmen Vorverstärker (PA) verbunden sind, wobei jeder Ausgang (V+, V-) der Verbindungspunkt zwischen einem der Widerstände (R) und einem der Tunnelmagnetowiderstandssensoren (301, 302) ist.

3. System (S) zur Unterdrückung des Niederfrequenzrauschens von magnetoresistiven Tunnelmagnetowiderstandssensoren nach Anspruch 1, **dadurch gekennzeichnet, dass** die Messvorrichtung (D) ein erstes (401, 401a) und ein zweites (402, 402a) Paar von Tunnelmagnetowiderstandssensoren und einen Vorverstärker (PA) mit niedrigem Rauschen umfasst, wobei die Sensoren des ersten Paars (401, 401a) eine umgekehrte Antwort in Bezug auf die Sensoren des zweiten Paars (402, 402a) haben, wobei die Tunnelmagnetowiderstandssensoren (401, 401a, 402, 402a) in einer Brückenschaltung angeordnet sind, die einen ersten Arm (B1) und einen zweiten Arm (B2) umfasst, wobei die beiden Arme parallel geschaltet sind und jeder der Arme einen Tunnelmagnetowiderstandssensor des ersten Paars (401, 401a) und einen Tunnelmagnetowiderstandssensor des zweiten Paars (402, 402a) umfasst und die Brückenschaltung ferner einen ersten (V+) und einen zweiten (V-) Ausgang umfasst, wobei beide Ausgänge mit dem rauscharmen Vorverstärker (PA) verbunden sind, wobei jeder Ausgang (V+, V-) der Verbindungspunkt zwischen einem Tunnelmagnetowiderstandssensor des ersten Paares (401, 401a) und einem Tunnelmagnetowiderstandssensor des zweiten Paares (402, 402a) ist.

4. System (S) zur Unterdrückung des Niederfrequenzrauschens von magnetoresistiven Tunnelmagnetowiderstandssensoren nach Anspruch 2 oder Anspruch 3, **dadurch gekennzeichnet, dass** die Halbbrücken- oder Brückenschaltung an eine Spannung Vb angeschlossen ist, wobei die Spannung Vb durch die Modulationsmittel M gesteuert wird.

5. System (S) zur Unterdrückung des Niederfrequenzrauschens von magnetoresistiven Tunnelmagnetowiderstandssensoren nach Anspruch 2 oder Anspruch 3, **dadurch gekennzeichnet, dass** die Halbbrücken- oder Brückenschaltung an eine erste Spannung Vb/2 und eine zweite Spannung -Vb/2 angeschlossen ist, wobei die Spannungen Vb/2 und -Vb/2 durch die Modulationsmittel M gesteuert werden.

6. System (S) zur Unterdrückung des Niederfrequenzrauschens von Tunnelmagnetowiderstandssensoren nach einem der vorhergehenden Ansprüche, **dadurch gekennzeichnet, dass** jeder Tunnelmagnetowiderstandssensor (C) durch einen Satz von in Reihe geschalteten Tunnelmagnetowiderstandsübergängen gebildet wird.

7. System (S) zur Unterdrückung des Niederfrequenzrauschens von magnetoresistiven Tunnelmagnetowiderstandssensoren nach einem der vorhergehenden Ansprüche, **dadurch gekennzeichnet, dass** die Messvorrichtung (D) Mittel zur lokalen Erwärmung umfasst, so dass die Referenzschicht (703, 704) von mindestens einem der Tunnelmagnetowiderstandssensoren umgestülpt wird.

8. System (S) zur Unterdrückung des Niederfrequenzrauschens von Tunnelmagnetowiderstandssensoren nach einem der vorhergehenden Ansprüche, **dadurch gekennzeichnet, dass** die Modulationsmittel (M) einen allgemeinen Hochfrequenztakt zur Erzeugung eines Signals (1601) zur Umschaltung zwischen dem ersten Betriebspunkt (801) und dem zweiten Betriebspunkt (802) umfassen.

9. System (S) zur Unterdrückung des Niederfrequenzrauschens nach dem vorhergehenden Anspruch und Anspruch 3 oder Anspruch 4, **dadurch gekennzeichnet, dass** das Schaltsignal (1601) die zeitlich veränderliche Spannung Vb umfasst, wobei das Signal mit der Halbbrückenschaltung oder der Brückenschaltung verbunden ist, wobei die Spannung Vb dem Umschalten der Tunnelmagnetowiderstandssensoren zwischen dem ersten Betriebspunkt (801) und dem zweiten Betriebspunkt (802) dient.

10. Verfahren (1) zur Unterdrückung des Niederfrequenzrauschens, das mit der Messung eines Magnetfelds (B) durch eine Messvorrichtung (D) verbunden ist, die mindestens einen Tunnelmagnetowiderstandssensor (C) umfasst, wobei das Verfahren die folgenden Schritte umfasst:
- Identifizieren (ID) eines ersten (801) und eines zweiten (802) Betriebspunkts des Tunnelmagnetowiderstandssensors (C), wobei der Tunnelmagnetowiderstandssensor eine erste Empfindlichkeit (S1) am ersten Betriebspunkt (801) und eine zweite Empfindlichkeit (S2) am zweiten Betriebspunkt (802) aufweist, wobei sich die Empfindlichkeit (S2) am zweiten Betriebspunkt von der ersten Empfindlichkeit (S1) unterscheidet;
wobei das Verfahren außerdem durch die folgenden Schritte gekennzeichnet ist:
- Modulieren (MOD) der Empfindlichkeit des Tunnelmagnetowiderstandssensors (C) durch Umschalten des Tunnelmagnetowiderstandssensors (C) vom ersten Betriebspunkt (801) mit der ersten Empfindlichkeit (S1) auf den zweiten **Betriebspunkt** (802) mit der zweiten Empfindlichkeit (S2) und vom zweiten Betriebspunkt (802) auf den ersten Betriebspunkt (801);
- Bei der Modulation (MOD) Messen (MES) einer ersten Antwort (M1) der Messvorrichtung (D) bei Vorhandensein des Magnetfelds (B) am ersten Betriebspunkt (801) und einer zweiten Antwort (M2) der Messvorrichtung (D) bei Vorhandensein des Magnetfelds (B) am zweiten Betriebspunkt (802);
- Berechnen einer Linearkombination (LIN) aus der ersten Antwort (M1) und der zweiten Antwort (M2) der Messvorrichtung (D).

## Claims

1. System (S) for suppressing low frequency noise of magnetoresistive sensors with tunnel magnetoresistance (C), said suppression system (S) including a device (D) for measuring a magnetic field (B) and modulation means (M), said suppression system (S) comprising :
- The device (D) including at least one tunnel magnetoresistance sensor (C), said tunnel magnetoresistance sensor (C) having a first sensitivity (S1) at a first operating point (801) and a second sensitivity (S2) at a second operating point (802), the second sensitivity (S2) at the second operating point (802) being different from the first sensitivity (S1) at the first operating point (801);
said system being **characterized in that** it further comprises:
- The modulation means (M) being suitable to switching the tunnel magnetoresistance sensor (C) from the first operating point (801) to the second operating point (802) and from the second operating point (802) to the first operating point (801), said modulation means (M) having a first configuration corresponding to the first operating point (801) and a second configuration corresponding to the second operating point (802);
- Means (T) for processing the signal derived from the device (D) for measuring a magnetic field (B), said processing means (T) being suited to making a linear combination of a first response (M1) of the measuring device (D) in the presence of the magnetic field (B) at the first operating point (801) corresponding to the first configuration of the modulation means (M) and a second response (M2) of the measuring device (D) in the presence of the magnetic field (B) at the second operating point (802) corresponding to the second configuration of the modulation means (M).

2. System (S) for suppressing low frequency noise of magnetoresistive sensors with tunnel magnetoresistance according to the preceding claim **characterised in that** the device (D) for measuring a magnetic field (B) includes two tunnel magnetoresistance sensors (301, 302) arranged according to a half-bridge arrangement and a low noise preamplifier (PA), the two tunnel magnetoresistance sensors (C) having an inverse response to the magnetic field, the half-bridge arrangement including a first arm (B1) and a second arm (B2), the two arms being connected in parallel, each of the arms including a resistor (R) and one of the tunnel magnetoresistance sensors (301,302), the half-bridge arrangement further including a first (V+) and a second (V-) output, the two outputs being connected to the low noise preamplifier (PA), each output (V+, V-) being the junction point between one of the resistors (R) and one of the tunnel magnetoresistance sensors (301, 302).

3. System (S) for suppressing low frequency noise of magnetoresistive sensors with tunnel magnetoresistance according to claim 1 **characterised in that** the measuring device (D) includes a first (401, 401a) and a second (402, 402a) pair of tunnel magnetoresistance sensors and a low noise preamplifier (PA), the sensors of the first pair (401, 401a) having an inverse response compared to the sensors of the second pair (402, 402a), the tunnel magnetoresistance sensors (401, 401a, 402, 402a) being arranged according to a bridge arrangement, the bridge arrangement including a first arm (B1) and a second arm (B2), the two arms being connected in parallel, each of the arms including a tunnel magnetoresistance sensor of the first pair (401, 401a) and a tunnel magnetoresistance sensor of the second pair (402, 402a), the bridge arrangement further including a first (V+) and a second (V-) output, the two outputs being connected to the low noise preamplifier (PA), each output (V+, V) being the junction point between a tunnel magnetoresistance sensor of the first pair (401, 401a) and a tunnel magnetoresistance sensor of the second pair (402, 402a).

4. System (S) for suppressing low frequency noise of magnetoresistive sensors with tunnel magnetoresistance according to claim 2 or claim 3 **characterised in that** the half-bridge or bridge arrangement is connected to a voltage Vb, the voltage Vb being managed by the modulation means M.

5. System (S) for suppressing low frequency noise of magnetoresistive sensors with tunnel magnetoresistance according to claim 2 or claim 3 **characterised in that** the half-bridge or bridge arrangement is connected to a first voltage Vb/2 and to a second voltage -Vb/2, the voltages Vb/2 and -Vb/2 being managed by the modulation means M.

6. System (S) for suppressing low frequency noise of tunnel magnetoresistance sensors according to one of the preceding claims **characterised in that** each tunnel magnetoresistance sensor (C) is formed by a set of tunnel magnetoresistance junctions connected in series.

7. System (S) for suppressing low frequency noise of magnetoresistive sensors with tunnel magnetoresistance according to one of the preceding claims **characterised in that** the measuring device (D) includes local heating means so as to flip the reference layer (703, 704) of at least one of the tunnel magnetoresistance sensors.

8. System (S) for suppressing low frequency noise of tunnel magnetoresistance sensors according to one of the preceding claims **characterised in that** the modulation means (M) include a high frequency master clock for the generation of a signal (1601) for switching between the first operating point (801) and the second operating point (802).

9. System (S) for suppressing low frequency noise according to the preceding claim and claim 3 or claim 4 **characterised in that** the switching signal (1601) includes the time variable voltage Vb, said signal being connected to the half-bridge arrangement or to the bridge arrangement, the voltage Vb being intended to switch the tunnel magnetoresistance sensors between the first operating point (801) and the second operating point (802).

10. Method (1) for suppressing low frequency noise associated with the measurement of a magnetic field (B) by a measuring device (D) including at least one tunnel magnetoresistance sensor (C), said method including the following steps:
- Identifying (ID) a first (801) and a second (802) operating point of the tunnel magnetoresistance sensor (C), the tunnel magnetoresistance sensor having a first sensitivity (S1) at the first operating point (801) and a second sensitivity (S2) at the second operating point (802), the sensitivity (S2) at the second operating point being different from the first sensitivity (S1);
Said method being **characterized in that** it further comprises the following steps:
- Modulating (MOD) the sensitivity of the tunnel magnetoresistance sensor (C) by switching the tunnel magnetoresistance sensor (C) from the first operating point (801) having the first sensitivity (S1) to the second operating point (802) having the second sensitivity (S2) and from the second operating point (802) to the first operating point (801);
- During the modulation (MOD), measuring (MES) a first response (M1) of the measuring device (D) in the presence of the magnetic field (B) at the first operating point (801) and a second response (M2) of the measuring device (D) in the presence of the magnetic field (B) at the second operating point (802);
- Calculating a linear combination (LIN) of the first response (M1) and the second response (M2) of the measuring device (D).
